(19) Europäisches Patentamt

European Patent Office

Office européen des brevets

(11) EP 0 491 090 B1

(12) EUROPEAN PATENT SPECIFICATION

(45) Date of publication and mention
of the grant of the patent:
**12.03.1997 Bulletin 1997/11**

(51) Int Cl.$^6$: **H04L 7/033**

(21) Application number: **90203446.1**

(22) Date of filing: **18.12.1990**

(54) **Synchronizing circuit**

Synchronisationsschaltung

Circuit de synchronisation

(84) Designated Contracting States:
**AT BE CH DE ES FR GB IT LI NL SE**

(43) Date of publication of application:
**24.06.1992 Bulletin 1992/26**

(73) Proprietor: **ALCATEL BELL
Naamloze Vennootschap
B-2018 Antwerpen 1 (BE)**

(72) Inventors:
• **Ampe, Patrick
B-8000 Brugge 3 (BE)**
• **Van de Pol, Daniel Frans Jozefina
B-2930 Brasschaat (BE)**
• **Cloetens, Leon
B-3500 Hasselt (BE)**

(56) References cited:
**EP-A- 0 054 322        WO-A-89/09520
US-A- 4 706 033**

## Description

The present invention relates to a synchronizing circuit for synchronizing a digital input signal and a clock signal, said circuit including a detection circuit to detect the presence/absence of synchronism between said input signal and said clock signal and to accordingly provide a phase adjustment signal indicative of said presence/absence of synchronism and a phase adjustment circuit controlled by said phase adjustment signal to perform a relative phase shift between said input signal and said clock signal when absence of synchronism is detected and providing an output signal synchronized with said clock signal.

Such a synchronizing circuit is already known in the art, e.g. from the International Patent Application WO-A-8 909 520. In this known synchronizing circuit the detection circuit detects the presence/absence of synchronism between the digital input signal and the clock signal by interpreting the relationship between at least two samples of a regenerated output signal which is obtained by passing the input signal through the phase adjustment circuit comprising a variable delay circuit covering one period of the input signal. This phase adjustment circuit, under the control of the phase adjustment signal generated by the detection circuit, performs a relative phase shift between the regenerated output data signal and the clock signal by adapting the above mentioned variable delay value.

A first drawback of this known synchronizing circuit is that the detection circuit operates directly on the input signal since it successively subjects this input signal to different delays, in a stepwise manner and under control of the phase adjustment signal, to reach synchronism. This means that the time to reach synchronism may be relatively high when many successive delays are necessary, which is another drawback of the existing synchronizing circuit.

Still another drawback is that the samples of the regenerated output have to be taken within half of the period of the input signal and at a very small time interval which implies a complex and accurate delay circuit. Such a delay circuit may be relatively expensive, especially when the synchronizing circuit has to operate at high frequency thus requiring technologies like gallium arsenide.

A first object of the present invention is to provide a synchronizing circuit of the above type but without operating on the input signal.

According to the invention this object is achieved due to the fact that said detection circuit detects said presence/absence of synchronism between said input signal, which is synchronized with a second clock signal, and the first mentioned clock signal by detecting said presence/absence of synchronism between said first clock signal and a third clock signal which is also synchronized with said second clock signal.

Because the third clock signal is synchronized with the same clock signal as the input signal the detection circuit is able to detect the presence/absence of synchronism between the input signal and the first clock signal by operating on the third clock signal, the input signal remaining unchanged until lack of synchronism is detected.

Another object of the present invention is to provide a synchronizing circuit of the above type without the use of a complex delay circuit and the need for successive delays, thus reducing the time to reach synchronism.

According to the invention this second object is achieved due to the fact that said detection circuit includes

a first pulse generator providing a periodic enabling/disabling first pulse waveform synchronized with said first clock signal and defining sampling enabling and disabling first time intervals;

a first sampling and register means which during said sampling enabling first time intervals and at sampling instants defined by predetermined edges of said first clock signal samples said third clock signal, thereby providing and registering first sample values;

a second sampling and register means coupled with said first sampling means and which during said sampling enabling first time intervals and at sampling instants defined by predetermined edges of said first clock signal samples said first sample values, thereby providing and registering second sample values equal to previous first sample values;

and gating means to derive from said first and second sample values an error signal indicative of said presence/absence of synchronism between said first and said third clock signals and therefore between said first clock signal and said input signal.

Due to the known form of the third clock signal the detection circuit is aware of the expected relationship of first and second sample values of the third clock signal taken at same relative instants with respect to the third clock period and may thus detect a presence/absence of synchronism by interpreting this relationship. Therefore these samples can be taken at intervals equal to $n \times \frac{T}{2}$, where n is an integer and T represents the period of the third clock signal and therefore also of the input signal. As a consequence there is no need for a complex delay circuit as in the known synchronizing circuit to take samples within T/2 and with a very small interval to detect lack of synchronism. When lack of synchronism is detected, a relative phase shift, under control of the phase adjustment signal, between the input signal and the first clock signal ensures return to synchronism in one step thus avoiding successive delays and reducing the time needed to reach this synchronism.

The above mentioned and other objects and features of the invention will become more apparent and the invention itself will be best understood by referring to the following description of an embodiment taken in conjunction with the accompanying drawings wherein :

Fig. 1 represents a synchronizing circuit SC according to the invention;
Fig. 2 shows D-flipflop FC2 of Fig. 1 in more detail;
Fig. 3 represents D-flipflop FE1 of Fig. 1 in more detail;
Fig. 4 shows pulse waveforms appearing at various points of the circuit of Fig. 1 in case of synchronism;
Fig. 5 represents pulse waveforms appearing at various points of the circuit of Fig. 1 in case of lack of synchronism.

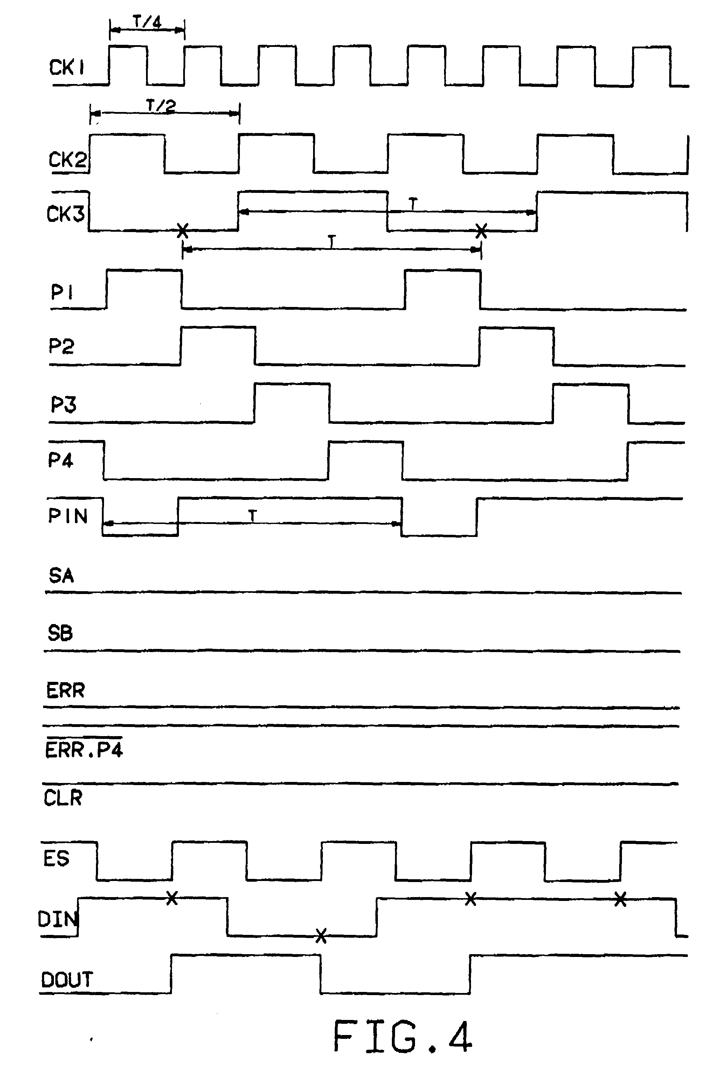

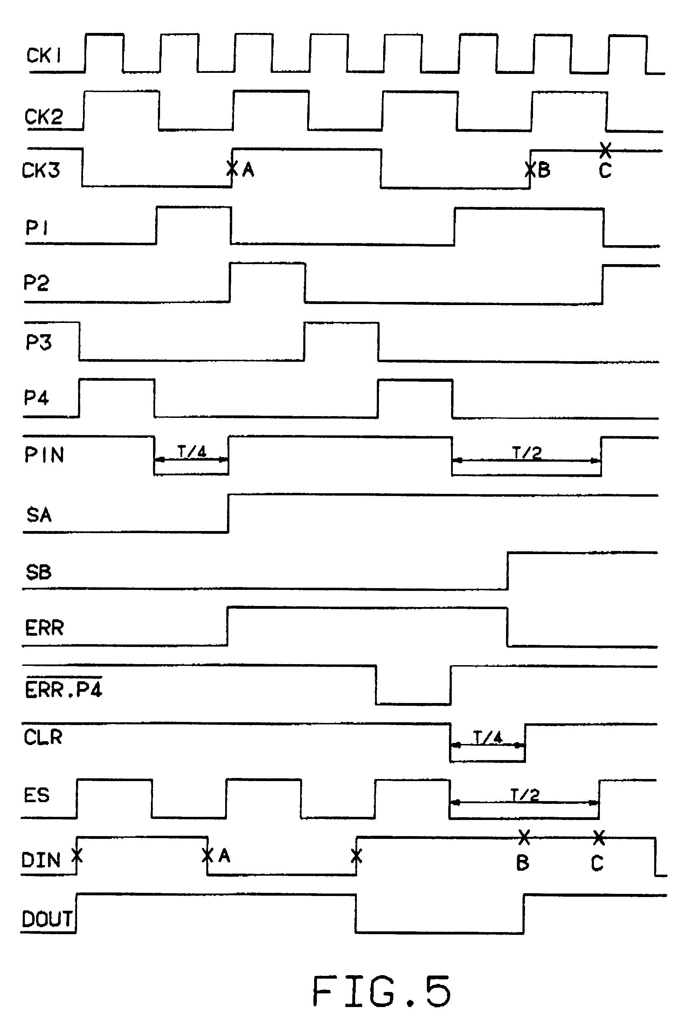

It has to be kept in mind, when looking at Figs 4 and 5, that a first signal derived from a second signal always has a small time delay with respect to the second one due to the technology used to perform this derivation. However, in order to simplify these figures the delays have not been represented, but should be taken into account to identify "the next or first rising edge" whenever specified in the following description.

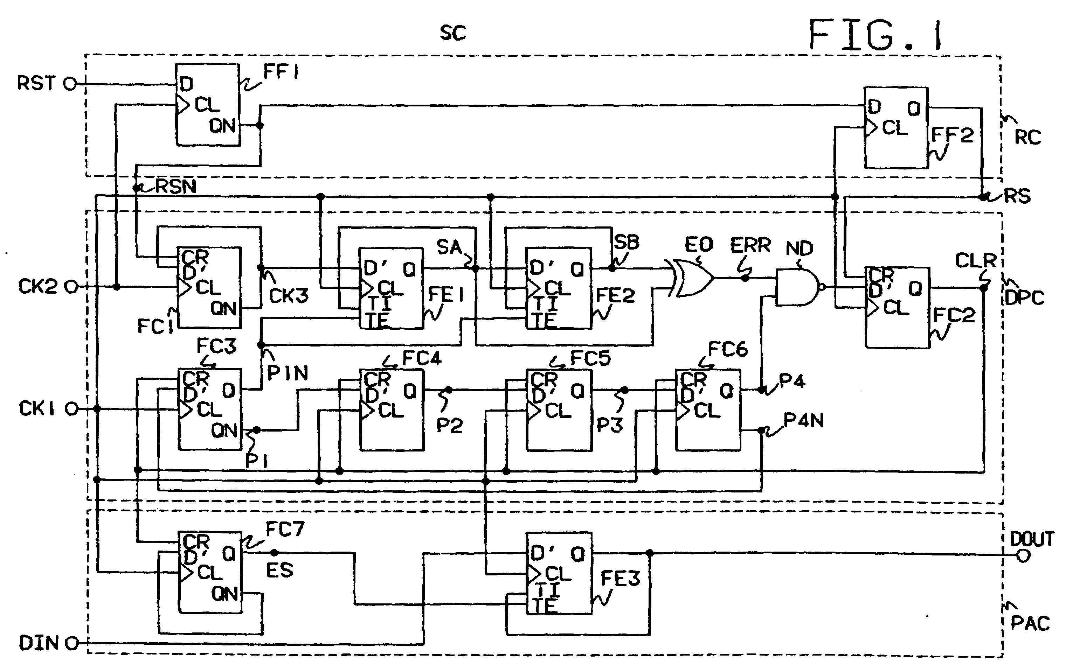

The synchronizing circuit SC shown in Fig. 1 is used in a BroadBand Integrated Services Digital Network (BBISDN) and more particularly at the transmit side of a receiver/transmitter. Therein a received input digital data stream DIN organized as byte data and synchronized with a 75 MHz clock signal CK2 is first synchronized with a 150 MMHz clock signal CK1 and this synchronized data DOUT is multiplexed afterwards to an output digital data stream organized as 4-bit data at the frequency of and synchronized with clock signal CK1. CK1 and CK2 shown in Figs 4 and 5 have a period equal to T/4 and T/2 respectively.

The circuit SC has reset input terminal RST, clock input terminal CK1, clock input terminal CK2 and data input terminal DIN to which a reset input signal RST, the clock signal CK1, the clock signal CK2 and the input signal DIN are applied respectively, and a data output terminal DOUT on which the output data stream DOUT is generated. The circuit SC comprises a reset circuit RC, a detection and auxiliary phase adjustment circuit DPC and a main phase adjustment circuit PAC.

The circuit SC includes the following circuitry :

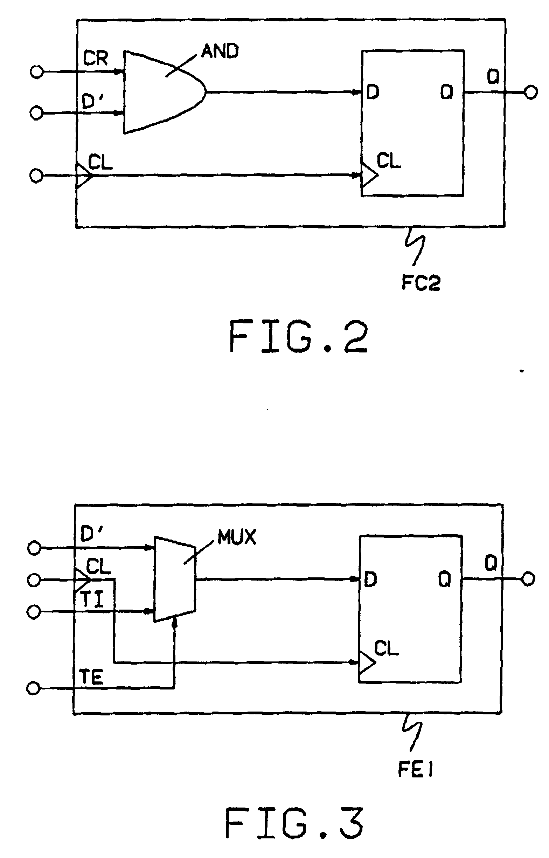

- usual D-flipflops, FF1, FF2 with a data input D, a clock input CL, a Q-output and a QN-output;
- D-flipflops with a clear port, FC1 and FC2 of which only FC2 is shown in detail in Fig. 2. Such a D-flipflop comprises a D-flipflop proper and an AND gate AND. The inputs of the gate are constituted by a data input D' and a control input CR, and its output is connected to the data input D of the D-flipflop proper ;
- D-flipflops with a multiplexer FE1 to FE3, where only FE1 is represented in detail in Fig. 3. Such a D-flipflop comprises a D-flipflop proper and a two input/one output Multiplexer MUX. This MUX has a data input D', a data input TI, a selection input TE and an output which is connected to the data input D of the D-flipflop proper. Depending on the value of the selection signal applied to the TE port being low or high, either the signal applied to the D' port or that applied to the TI port is fed to the input port of the D-flipflop proper;
- an exclusive-OR gate EO;
- a NAND gate ND.

The reset circuit RC includes D-flipflop FF1 of which the D-input and the clock input CL are connected to the reset input terminal RST and to the clock input terminal CK2 respectively. The QN-output RSN of FF1 is connected to the input CR of FC1 as well as to the D-input of D-flipflop FF2 which is controlled by CK1. The Q-output RS of FF2 is connected to the input CR of FC2.

The detection and auxiliary phase adjustment circuit DPC includes D-flipflops FC1 to FC6, FE1 and FE2, exclusive -OR gate EO and NAND gate ND.

The clock input terminal CK2 is connected to the clock input CL of FC1 whose QN-output CK3 is fed back to its data input D'. FC1 is a pulse generator generating a clock signal CK3 having half the frequency of CK2, as shown in Figs 4 and 5. Since the clock signal CK3 and the input signal are both synchronized with the clock signal CK2, the presence/absence of synchronism between DIN and CK1 can be detected by detecting the presence/absence of synchronism between CK3 and CK1. In other words, the clock signal CK3 is representative for the input signal DIN.

The QN output CK3 of FC1 is also connected to the D'-input of FE1 whose Q-output SA is likewise connected to the D'-input of FE2 having Q-output SB. FE1 and FE2 are connected in a similar way since their Q-output SA, SB is fed back to their input TI, their clock input CL is connected to clock input terminal CK1 and their selection input TE is connected to the Q-output P1N of FC3. FE1 and FE2 constitute first and second sampling and register circuits able to sample CK3 and SA respectively at sampling instants defined by the rising edges of the clock CK1 and during sampling enabling or low time intervals defined by the sampling enabling/disabling pulse waveform P1N generated at the Q-output P1N of FC3.

The Q-outputs SA and SB are connected to respective inputs of the exclusive-OR gate EO which constitutes an error detection circuit. Its output ERR and the Q-output P4 of FC6 are connected to the D'-input of FC2, the clock input CL of which is connected to clock input terminal CK1. FC2 is a register used to memorize the error signal generated by gate EO and which provides on its Q-output CLR a phase adjustment signal CLR. The latter output CLR is connected to the clear inputs CR of FC3 to FC6 and of FC7 to control phase adjustment.

The 4 D-flipflops FC3 to FC6 are connected in cascade and in a closed loop so as to form a 4-stage closed loop shift register with a shift input controlled by CK1. A phase inversion takes place between FC3 and FC4 as well as between FC6 and FC3 since the QN-output of FC3 and FC6 are connected to the D'-input of FC4 and FC3 respectively. This 4-stage shift register constitutes a pulse generator generating the pulse waveforms P1 and P2 to P4 (Fig. 4, 5) at the like named QN-output P1 of FC3 and at the like named Q-outputs P2, P3 and P4 of FC4, FC5 and FC6 respectively. It further generates the above mentioned sampling enabling/disabling pulse waveform P1N (Fig. 4, 5) at the Q-output of FC3. Hereby the low time intervals constitute the enabling time interval and have a repetition period equal to T.

The main phase adjustment circuit PAC comprises D-flipflops FC7 and FE3. FC7 is connected in a similar way as FC1 except that it is connected to CK1 instead of CK2 for FC2. FC7 therefore constitutes a pulse generator generating the signal ES at its Q-output which has half the frequency of CK1 and therefore the frequency of CK2. The signal ES is another sampling enabling/disabling signal defining sampling enabling (low) and disabling (high) time intervals.

FE3 is connected in a similar way as FE1 and FE2 and therefore also constitutes a sampling and register circuit. More particularly its inputs D', CL, TI and TE are connected to the data input terminal DIN, the clock input terminal CK1, its Q-output DOUT and the Q-output ES of FC7 respectively. FE3 samples DIN at sampling instants defined by rising edges of the clock CK1 and during sampling enabling or low time intervals defined by the sampling enabling/disabling signal ES. It provides the output data signal DOUT at its output terminal DOUT.

The above synchronizing circuit operates as described hereafter.

First reference is made to Fig. 4, it being assumed that no lack of synchronism is detected.

When the reset signal RST applied to the input terminal RST of the reset circuit RC is high, the latter circuit produces at the next rising edge of CK2 a low reset signal RSN at the QN-output of FF1. The signal RSN, synchronized with CK2, gives rise to a high output signal at the QN-output of the pulse generator FC1 thus starting the operation thereof. FC1 thereby produces the clock waveform CK3 at its QN-output CK3.

The signal RSN is also applied to the D-input of FF2 which at its Q-output RS produces a reset signal RS synchronized with CK1. This signal RS is supplied to the clear port of FC2 which accordingly generates a low phase adjustment signal CLR at its Q-output CLR. The latter signal CLR resets at the same time both the pulse generators FC3/FC6 and FC7 which then start their operation and produce the waveforms P1 to P4, P1N and ES at respective outputs. As already mentioned above the low intervals of P1N and ES are sampling enabling time intervals.

During each of the sampling enabling time intervals of P1N and at a sampling instant defined by the first rising edge of CK1 occurring within that interval the clock signal CK3 in sampled and registered by FE1, thereby producing a new sample value SA, and simultaneously the sample value SA of the immediately preceding sampling operation which occurred a time T ago is sampled and registered by FE2, thereby producing a new sample value SB equal to the previous sample value SA. In other words, during each sampling operation two sample values of CK3, at a distance equal to T, are obtained.

During the low time intervals of the gating waveform P4 the output signal of the gate ND is high so that at the occurrence of each rising edge of CK1 it is registered in the flipflop FC2 thereby producing a high output signal CLR at the Q-output thereof. This signal CLR has no effect neither on FC3/FC6 nor on FC7.

When, as assumed, no phase shifting has occurred between two successive sampling instants separated by the time interval T both the above sampled values are equal so that the error signal ERR provided at the output of gate EO then remains low. As a consequence nothing is changed to the condition of the output signal CLR after the signal ERR has been gated through gate ND under the control of a high pulse of the waveform P4.

In a similar way as for FE1, but now during the low intervals provided by ES and thus at twice the frequency of P1N, again at sampling instants defined by the rising edges of CK1 occurring within these intervals, the input signal DIN is sampled by FE3, thereby producing a sample data output signal DOUT at its Q-output DOUT. Since the frequency of the sampling enabling signal ES is equal to the frequency of CK2 with which DIN is synchronized, the sample data output signal DOUT represents the input signal DIN, but now synchronized with CK1.

Since the clock signal CK3 is representative for the input signal DIN and since for the case represented in Fig. 4 there is no need for a relative phase adjustment between CK3 and CK1, there is also no need for a relative phase adjustment between DIN and CK1.

Reference is now made to Fig. 5 for the operation of the circuit in case of lack of synchronism is detected.

Such a lack of synchronism between the input signal DIN synchronized with CK2 and the clock signal CK1 is reflected in a lack of synchronism between the clock signal CK3 and the clock signal CK1, since both are synchronized with CK2.

In Fig. 5 a lack of synchronism occurs because both CK3 and DIN, are sampled in the neighbourhood of the edge A. As a consequence the new sampling value SA provided by FE1 becomes high whereas the new sample value SB which is equal to the previous sample value SA is still low. Accordingly the gate EO provides a high error signal ERR and the latter is registered in the register FC2 under the control of a high pulse of the signal P4 and via the gate ND. The Q-output CLR of this register thus becomes low during a time interval of duration T/4 and following the high pulse of P4.

This pulse is fed to the clear input CR of both FC3 and FC7, at the beginning of an enabling or low period of the enabling/disabling pulse waveforms and will force the latter again to a low period at the next rising edge of CK1. This means that the enabling or low period of the enabling/disabling pulse waveforms is extended from T/4 to T/2 towards the right so that during the extended enabling or low interval of P1N and ES CK3 and DIN are sampled not only in the sampling instants B but also in the sampling instants C. Since the error was due to a sampling operation at sampling instants A in the neighbourhood of an edge of CK3 and DIN it is clear that the sampling operation at sampling instant C takes place in the neighbourhood of the middle between two such edges. In this way a return to synchronism is ensured. FC4 to FC6 receive the CLR signal on their clear input CR at the same instant as FC3, thus keeping their output signals P2 to P4 low. So, the 4 phase shifter is restarted at such an instant as to provide output signals P1N, P1 to P4 shifted over T/4 to the right ensuring a sampling of CK3 during the enabling or low period of P1N in the neighbourhood of the middle between two edges of CK3 implying a relative phase shift between the sampled third clock and the first clock CK1.

In a similar way FC7 is restarted and its output signal ES is shifted over T/4 to the right. This results in a relative phase shift between the regenerated DIN signal and CK1, thus synchronizing DIN and CK1.

While the principles of the invention have been described above in connection with specific apparatus, it is to be clearly understood that this description is made only by way of example and not as a limitation on the scope of the invention.

**Claims**

1. Synchronizing circuit for synchronizing a digital input signal (DIN) and a clock signal (CK1), said circuit including a detection circuit (DPC) to detect the presence/absence of synchronism between said input signal (DIN) and said clock signal (CK1) and to accordingly provide a phase adjustment signal (CLR) indicative of said presence/absence of synchronism and a phase adjustment circuit (PAC) controlled by said phase adjustment signal (CLR) to perform a relative phase shift between said input signal (DIN) and said clock signal (CK1) when absence of synchronism is detected and providing an output signal (DOUT) synchronized with said clock signal (CK1), characterized in that said detection circuit detects said presence/absence of synchronism between said input signal (DIN), which is synchronized with a second clock signal (CK2), and the first mentioned clock signal (CK1) by detecting said presence/absence of synchronism between said first clock signal (CK1) and a third clock signal (CK3) which is also synchronized with said second clock signal (CK2).

2. Synchronizing circuit according to claim 1, characterized in that said detection circuit (DPC) includes

   a first pulse generator (FC3-FC6) providing a periodic enabling/disabling first pulse waveform (P1N) synchronized with said first clock signal (CK1) and defining sampling enabling and disabling first time intervals;
   a first sampling and register means (FE1) which during said sampling enabling first time intervals and at sampling instants defined by predetermined edges of said first clock signal (CK1) samples said third clock signal (CK3), thereby providing and registering first sample values (SA);
   a second sampling and register means (FE2) coupled with said first sampling means and which during said sampling enabling first time intervals and at sampling instants defined by predetermined edges of said first clock signal (CK1) samples said first sample values (SA), thereby providing and registering second sample values (SB) equal to previous first sample values;
   and gating means (EO) to derive from said first (SA) and second (SB) sample values an error signal (ERR) indicative of said presence/absence of synchronism between said first (CK1) and said third (CK3) clock signals and therefore between said first clock signal (CK1) and said input signal (DIN).

3. Synchronizing circuit according to claim 1, characterized in that said detection circuit (DPC) also includes an auxiliary phase adjustment circuit to perform a relative phase shift between said first clock signal (CK1) and said sampled third clock signal (CK3),

4. Synchronizing circuit according to claim 2, characterized in that the interval between consecutive sampling instants is equal to a multiple of half the period of said third clock signal (CK3).

5. Synchronizing circuit according to claim 2, characterized in that said detection circuit (DPC) includes a first register means (ND-FC2) to register said error signal (ERR) and to provide at its output said phase adjustment signal (CLR).

6. Synchronizing circuit according to claim 5, characterized in that said first pulse generator (FC3-FC6) also provides a gating signal (P4) allowing said error signal (ERR) to be registered in said first register means (ND - FC2) through a logic gate (ND) whose output is coupled with a first D-flipflop (FC2) controlled by said first clock signal (CK1) and provides said phase adjustment signal (CLR) at its output (Q).

7. Synchronizing circuit according to claims 2 and 3, characterized in that said auxiliary phase adjustment circuit is able under the control of said phase adjustment signal to phase shift said enabling first time intervals over the duration thereof and such that the first of these phase shifted enabling first time intervals covers two consecutive first and second sampling instants, whilst the other phase shifted enabling first time intervals each cover only a second sampling instant.

8. Synchronizing circuit according to claim 1, characterized in that said phase adjustment circuit (PAC) includes a second pulse generator (FC7) providing a periodic enabling/disabling second pulse waveform (ES) synchronized with said first clock (CK1) and defining sampling enabling and disabling second intervals and a third sampling and register circuit (FE3) which during said sampling enabling second intervals (ES) and at sampling instants defined by predetermined edges of said first clock signal (CK1) samples said input signal (DIN), thereby providing and registering said output signal (DOUT) synchronized with said first clock signal.

9. Synchronizing circuit according to claim 8, characterized in that said phase adjustment circuit (DPC) is able under the control of said phase adjustment signal to phase shift said enabling second time interval over the duration thereof and such that the first of these phase shifted enabling second time intervals covers two consecutive first and second sampling instants, whilst the other phase shifted enabling second time intervals each cover only a second sampling instant.

10. Synchronizing circuit according to claim 2, characterized in that the frequency of said first clock signal (CK1) is equal to twice the frequency of said second clock signal CK2, and that said first pulse generator is constituted by a closed loop four-stage shift register (FC3-FC6) with a shift input controlled by said first clock signal (CK1) and having first (FC3) and last (FC6) stages wherein signal inversion is performed, each of said stages (FC3-FC6) including a first AND gate coupled with the data input of a D-flipflop.

11. Synchronizing circuit according to claims 6, 7 and 10, characterized in that said phase adjustment signal (CLR) controls an input of the first AND gate associated to said first stage which provides said periodic enabling/disabling first pulse waveform (P1N) at its non-inverted output (Q) and that said gating signal (P4) is provided at the non-inverting output of said last stage (FL6) of said first pulse generator.

12. Synchronizing circuit according to claim 8 characterized in that the frequency of said first clock signal (CK1) is equal to twice the frequency of said second clock signal (CK2) and that said second pulse generator is constituted by an oscillator circuit (FC7) comprising a second AND gate coupled with the data input of a D-flipflop and controlled by said first clock signal (CK1), said phase adjustment signal (CLR) being applied to an input of said AND gate.

13. Synchronizing circuit according to claim 8, characterized in that said third sampling circuit (FE3) comprises a two input/one output multiplexer with a first input to which said output signal (DOUT) is applied, with a second input to which said input signal (DIN) is fed with a selection input controlled by said second pulse waveform (ES) and with an output coupled with a D-flipflop controlled by said first clock signal (CK1).

14. Synchronizing circuit according to claim 2, characterized in that said first sampling and register means consists of a two input/one output multiplexer with a first input to which said first sample values (SA) are applied, with a second input to which said third clock signal (CK3) is fed with a a selection input controlled by said first pulse waveform (P1N) and with an output coupled with a D-flipflop controlled by said first clock signal (CK1).

15. Synchronizing circuit according to claim 2, characterized in that said second sampling and register means consists of a two input/one output multiplexer with a first input to which said second sample values (SB) are applied, with a second input to which said first sample values (SA) are fed with a selection input controlled by said first pulse waveform (P1N) and with an output coupled with a D-flipflop controlled by said first clock signal (CK1).

**Patentansprüche**

1. Synchronisierschaltung zur Synchronisation eines digitalen Eingangssignals (DIN) und eines Taktsignals (CK1), wobei die Schaltung enthält: eine Erkennungsschaltung (DPC), um das Vorhandensein/Fehlen des Synchronismus zwischen dem Eingangssignal (DIN) und dem Taktsignal (CK1) zu erkennen und dementsprechend ein Phasenkorrektursignal (CLR) bereitzustellen, das das Vorhandensein/Fehlen des Synchronismus anzeigt, und eine Phasenkorrekturschaltung (PAC), die von dem Phasenkorrektursignal (CLR) gesteuert wird, um eine relative Phasenverschiebung zwischen dem Eingangssignal (DIN) und dem Taktsignal (CK1) auszuführen, wenn das Fehlen des Synchronismus festgestellt wird, und ein Ausgangssignal (DOUT) bereitzustellen, das mit dem Taktsignal (CK1) synchronisiert ist, dadurch gekennzeichnet, daß die Erkennungsschaltung das Vorhandensein/Fehlen des Synchronismus zwischen dem mit einem zweiten Taktsignal (CK2) synchronisierten Eingangssignal (DIN) und dem zuerst erwähnten Taktsignal (CK1) erkennt, indem das Vorhandensein/Fehlen des Synchronismus zwischen dem ersten Taktsignal (CK1) und einem dritten, ebenfalls mit dem zweiten Taktsignal (CK2) synchronisierten Taktsignal (CK3) festgestellt wird.

2. Synchronisierschaltung gemäß anspruch 1, dadurch gekennzeichnet, daß die Erkennungsschaltung (DPC) enthält:

einen ersten Impulsgenerator (FC3 bis FC6), der eine erste periodische Freigabe-/Sperr-Impulsverlaufsform (P1N) bereitstellt, die mit dem ersten Taktsignal (CK1) synchronisiert ist und erste Abtastfreigabe- und -Abtastsperr-Zeitintervalle definiert;

ein erstes Abtast- und Registermittel (FE1), das während der ersten Abtastfreigabe-Zeitintervalle und zu Abtastzeitpunkten, die von vorher festgelegten Flanken des ersten Taktsignals (CK1) definiert werden, das dritte Taktsignal (CK3) abtastet, wodurch erste Abtastwerte (SA) bereitgestellt und gespeichert werden;

ein zweites Abtast- und Registermittel (FE2), das mit dem ersten Abtastmittel verbunden ist und das während der ersten Abtastfreigabe-Zeitintervalle und zu Abtastzeitpunkten, die von vorher festgelegten Flanken des ersten Taktsignals (CK1) definiert werden, die ersten Abtastwerte (SA) abtastet, wodurch zweite Abtastwerte (SB), die mit den vorherigen ersten Abtastwerten übereinstimmen, bereitgestellt und gespeichert werden;

sowie Torschaltungsmittel (EO), um aus den ersten (SA) und zweiten (SB) Abtastwerten ein Fehlersignal (ERR) abzuleiten, das das Vorhandensein/Fehlen des Synchronismus zwischen den ersten (CK1) und dritten (CK3) Taktsignalen und demzufolge zwischen dem ersten Taktsignal (CK1) und dem Eingangssignal (DIN) anzeigt.

3. Synchronisierschaltung gemäß Anspruch 1, dadurch gekennzeichnet, daß die Erkennungsschaltung (DPC) auch eine Hilfsphasenkorrekturschaltung enhält, um eine relative Phasenverschiebung zwischen dem ersten Taktsignal (CK1) und dem abgetasteten dritten Taktsignal (CK3) auszuführen.

4. Synchronisierschaltung gemäß Anspruch 2, dadurch gekennzeichnet, daß das Intervall zwischen aufeinanderfolgenden Abtastzeitpunkten gleich einem Vielfachen der halben Periode des dritten Taktsignals (CK3) ist.

5. Synchronisierschaltung gemäß Anspruch 2, dadurch gekennzeichnet, daß die Erkennungsschaltung (DPC) ein erstes Registermittel (ND-FC2) enthält, um das Fehlersignal (ERR) zu speichern und an seinem Ausgang das Phasenkorrektursignal (CLR) bereitzustellen.

6. Synchronisierschaltung gemäß Anspruch 5, dadurch gekennzeichnet, daß der erste Impulsgenerator (FC3-FC6) auch ein Torschaltsignal (P4) bereitstellt, das es erlaubt, das Fehlersignal (ERR) in dem ersten Registermittel (ND-FC2) über ein Logikglied (ND) zu speichern, dessen Ausgang mit einem ersten D-Flip-Flop (FC2) verbunden ist, das von dem ersten Taktsignal (CK1) gesteuert wird und das Phasenkorrektursignal (CLR) an seinem Ausgang (Q) bereitstellt.

7. Synchronisierschaltung gemäß Anspruch 2 und 3, dadurch gekennzeichnet, daß die Hilfsphasenkorrekturschaltung unter der Steuerung des Phasenkorrektursignals die Phase der ersten Freigabezeitintervalle über deren Dauer verschieben kann, und zwar so, daß das erste dieser phasenverschobenen ersten Freigabezeitintervalle zwei aufeinanderfolgende erste und zweite Abtastzeitpunkte überdeckt, während die anderen ersten phasenverschobenen Freigabezeitintervalle jeweils nur einen zweiten Abtastzeitpunkt überdecken.

8. Synchronisierschaltung gemäß Anspruch 1, dadurch gekennzeichnet, daß die Phasenkorrekturschaltung (PAC) einen zweiten Impulsgenerator (FC7) enthält, der eine zweite periodische Freigabe-/Sperr-Impulsverlaufsform (ES) bereitstellt, die mit dem ersten Takt (CK1) synchronisiert ist und zweite Abtastfreigabe- und Abtastsperr-Intervalle definiert, sowie eine dritte Abtast- und Registerschaltung (FE3), die während der zweiten Abtastfreigabe-Intervalle (ES) und zu Abtastzeitpunkten, die von vorher festgelegten Flanken des ersten Taktsignals (CK1) definiert werden, das Eingangssignal (DIN) abtastet, wodurch das mit dem ersten Taktsignal synchronisierte Ausgangssignal (DOUT) bereitgestellt und gespeichert wird.

9. Synchronisierschaltung gemäß Anspruch 3, dadurch gekennzeichnet, daß die Phasenkorrekturschaltung (DPC) unter der Steuerung des Phasenkorrektursignals die Phase der zweiten Freigabezeitintervalle über deren Dauer verschieben kann, und zwar so, daß das erste dieser phasenverschobenen zweiten Freigabezeitintervalle zwei aufeinanderfolgende erste und zweite Abtastzeitpunkte überdeckt, während die anderen zweiten phasenverschobenen Zeitintervalle jeweils nur einen zweiten Abtastzeitpunkt überdecken.

10. Synchronisierschaltung gemäß Anspruch 2, dadurch gekennzeichnet, daß die Frequenz des ersten Taktsignals (CK1) gleich der doppelten Frequenz des zweiten Taktsignals CK2 ist, und daß der erste Impulsgenerator von einem zyklischen vierstufigen Schieberegister (FC3-FC6) gebildet wird, mit einem Schiebeeingang, der von dem ersten Taktsignal (CK1) gesteuert wird und mit einer ersten (FC3) und letzten (FC6) Stufe, in denen eine Signalumkehrung ausgeführt wird, wobei jede der Stufen (FC3-FC6) ein erstes UND-Glied enthält, das mit dem Dateneingang eines D-Flip-Flops verbunden ist.

11. Synchronisierschaltung gemäß Anspruch 6, 7 und 10, dadurch gekennzeichnet, daß das Phasenkorrektursignal (CLR) einen Eingang des ersten, der ersten Stufe zugeordneten UND-Gliedes steuert, das die erste periodische Freigabe-/Sperr-Impulsverlaufsform (PIN) an ihrem nichtnegierten Ausgang (Q) bereitstellt, sowie dadurch, daß das Torschaltungssignal (P4) am nichtnegierten Ausgang der letzten Stufe (FL6) des ersten Impulsgenerators bereitgestellt wird.

12. Synchronisierschaltung gemäß Anspruch 8, dadurch gekennzeichnet, daß die Frequenz des ersten Taktsignals (CK1) gleich der doppelten Frequenz des zweiten Taktsignals (CK2) ist, und daß der zweite Impulsgenerator von einer Oszillatorschaltung (FC7) gebildet wird, die ein zweites UND-Glied umfaßt, das mit dem Dateneingang eines D-Flip-Flops verbunden ist und von dem ersten Taktsignal (CK1) gesteuert wird, wobei das Phasenkorrektursignal (CLR) an den Eingang des UND-Gliedes angelegt wird.

13. Synchronisierschaltung gemäß Anspruch 8, dadurch gekennzeichnet, daß die dritte Abtastschaltung (FE3) einen Multiplexer mit zwei Eingängen und einem Ausgang umfaßt, mit einem ersten Eingang, an den das Ausgangssignal (DOUT) angelegt wird, mit einem zweiten Eingang, an den das Eingangssignal (DIN) angelegt wird, mit einem Auswahleingang, der von der zweiten Impulsverlaufsform (ES) gesteuert wird, und mit einem Ausgang, der mit einem D-Flip-Flop verbunden ist, das von dem ersten Taktsignal (CK1) gesteuert wird.

14. Synchronisierschaltung gemäß Anspruch 2, dadurch gekennzeichnet, daß das erste Abtast- und Registermittel aus einem Multiplexer mit zwei Eingängen und einem Ausgang besteht, mit einem ersten Eingang, an den die ersten Abtastwerte (SA) angelegt werden, mit einem zweiten Eingang, an den das dritte Taktsignal (CK3) angelegt wird, mit einem Auswahleingang, der von der ersten Impulsverlaufsform (P1N) gesteuert wird, und mit einem Ausgang, der mit einem D-Flip-Flop verbunden ist, das von dem ersten Taktsignal (CK1) gesteuert wird.

15. Synchronisierschaltung gemäß Anspruch 1, dadurch gekennzeichnet, daß das zweite Abtast- und registermittel aus einem Multiplexer mit zwei Eingängen und einem Ausgang besteht, mit einem ersten Eingang, an den die zweiten Abtastwerte (SB) angelegt werden, mit einem zweiten Eingang, an den die ersten Abtastwerte (SA) angelegt werden, mit einem Auswahleingang, der von der ersten Impulsverlaufsform (P1N) gesteuert wird, und mit einem Ausgang, der mit einem D-Flip-Flop verbunden ist, das von dem ersten Taktsignal (CK1) gesteuert wird.

## Revendications

1. Circuit de synchronisation permettant de synchroniser un signal d'entrée numérique (DIN) et un signal d'horloge (CK1), ledit circuit comportant un circuit de détection (DPC) permettant de détecter la présence/absence de synchronisme entre ledit signal d'entrée (DIN) et ledit signal d'horloge (CK1) et par conséquent de fournir un signal de réglage de la phase (CLR), indiquant ladite présence/absence de synchronisme et un circuit de réglage de la phase (PAC) commandé par ledit signal de réglage de la phase (CLR) pour effectuer un décalage de phase relatif entre ledit signal d'entrée (DIN) et ledit signal d'horloge (CK1) lorsqu'une absence de synchronisme est détectée et fournissant un signal de sortie (DOUT) synchronisé avec ledit signal d'horloge (CK1), caractérisé en ce que ledit circuit de détection détecte ladite présence/absence de synchronisme entre ledit signal d'entrée (DIN), qui est synchronisé avec un deuxième signal d'horloge (CK2), et le premier signal d'horloge mentionné (CK1) en détectant ladite présence/absence de synchronisme entre ledit premier signal d'horloge (CK1) et un troisième signal d'horloge (CK3) qui est également synchronisé avec ledit deuxième signal d'horloge (CK2).

2. Circuit de synchronisation selon la revendication 1, caractérisé en ce que ledit circuit de détection (DPC) comporte :

    un premier générateur d'impulsions (FC3-FC6) fournissant un premier signal impulsionnel de validation/invalidation périodique (PIN) synchronise avec ledit premier signal d'horloge (CK1), et définissant les premiers intervalles de temps de validation et d'invalidation de l'échantillonnage ;

un premier moyen d'échantillonnage et de mémorisation (FE1), qui, pendant lesdits premiers intervalles de temps de validation de l'échantillonnage et aux instants d'échantillonnage définis par les fronts prédéterminés dudit premier signal d'horloge (CK1) échantillonne ledit troisième signal d'horloge (CK3), fournissant et mémorisant ainsi les premières valeurs d'échantillon (SA) ;

un deuxième moyen d'échantillonnage et de mémorisation (FE2) couplé audit premier moyen d'échantillonnage et qui, pendant lesdits premiers intervalles de temps de validation de l'échantillonnage et aux instants d'échantillonnage définis par les fronts prédéterminés dudit premier signal d'horloge (CK1) échantillonne lesdites premières valeurs d'échantillon (SA), fournissant et mémorisant ainsi les deuxièmes valeurs d'échantillon (SB) égales aux premières valeurs d'échantillon précédentes ;

et un moyen de déblocage (EO) permettant de dégager desdites première (SA) et deuxième (SB) valeurs d'échantillon un signal d'erreur (ERR) indiquant ladite présence/absence de synchronisme entre ledit premier (CK1) et ledit troisième (CK3) signaux d'horloge et par conséquent entre ledit premier signal d'horloge (CK1) et ledit signal d'entrée (DIN).

3. Circuit de synchronisation selon la revendication 1, caractérisé en ce que ledit circuit de détection (DPC) comporte également un circuit de réglage de la phase auxiliaire permettant d'effectuer un décalage de phase relatif entre ledit premier signal d'horloge (CK1) et ledit troisième signal d'horloge échantillonné (CK3).

4. Circuit de synchronisation selon la revendication 2, caractérisé en ce que l'intervalle compris entre les instants d'échantillonnage consécutifs est égal à un multiple de la moitié de la période dudit troisième signal d'horloge (CK3).

5. Circuit de synchronisation selon la revendication 2, caractérisé en ce que ledit circuit de détection (DPC) comporte un premier moyen de mémorisation (ND-FC2) permettant de mémoriser ledit signal d'erreur (ERR) et de fournir au niveau de sa sortie ledit signal réglage de la phase (CLR).

6. Circuit de synchronisation selon la revendication 5, caractérisé en ce que ledit premier générateur d'impulsions (FC3-FC6) fournit également un signal de déblocage (P4) permettant au dit signal d'erreur (ERR) d'être mémorisé dans ledit premier moyen de mémorisation (ND-FC2) par l'intermédiaire d'une porte logique (ND) dont la sortie est couplée à une première bascule D (FC2) commandée par ledit premier signal d'horloge (CK1) et fournit ledit signal de réglage de la phase (CLR) au niveau de sa sortie (Q).

7. Circuit de synchronisation selon les revendications 2 et 3, caractérisé en ce que ledit circuit de réglage de la phase auxiliaire est capable, sous la commande dudit signal de réglage de la phase, de déphaser lesdits premiers intervalles de temps de validation sur la durée de ceux-ci et de sorte que le premier de ces premiers intervalles de temps de validation déphasés couvre deux Instant d'échantillonnage, à savoir un premier et un deuxième, alors que les autres premiers intervalles de temps de validation déphasés ne couvrent chacun qu'un deuxième instant d'échantillonnage.

8. Circuit de synchronisation selon la revendication 1, caractérisé en ce que ledit circuit de réglage de la phase (PAC) comporte un deuxième générateur d'impulsions (FC7), qui fournit un deuxième signal impulsionnel de validation/invalidation périodique (ES) synchronisé avec ladite première horloge (CK1) et définissant les deuxièmes intervalles de validation et d'invalidation de l'échantillonnage et un troisième circuit d'échantillonnage et de mémorisation (FE3) qui, pendant lesdits deuxièmes intervalles de validation de l'échantillonnage (ES) et aux instants d'échantillonnage définis par les fronts prédéterminés dudit premier signal d'horloge (CK1) échantillonne ledit signal d'entrée (DIN), fournissant et mémorisant ainsi ledit signal de sortie (DOUT) synchronisé avec ledit premier signal d'horloge.

9. Circuit de synchronisation selon la revendication 8, caractérisé en ce que ledit circuit de réglage de la phase (DPC) est capable, sous la commande dudit signal de réglage de la phase, de déphaser ledit deuxième intervalle de temps de validation sur la durée de celui-ci et de telle sorte que le premier des deuxièmes intervalles de temps de validation déphasée couvre deux instants d'échantillonnage consécutifs à savoir un premier et un deuxième, alors que les autres deuxièmes intervalles de temps de validation déphasée couvrent chacun seulement un deuxième instant d'échantillonnage.

10. Circuit de synchronisation selon la revendication 2, caractérisé en ce que la fréquence dudit premier signal d'horloge (CK1) est égale à deux fois la fréquence dudit deuxième signal d'horloge CK2, et en ce que ledit premier générateur d'impulsions est composé d'un registre de décalage à quatre étages et à boucle fermée (FC3-FC6) une entrée de décalage étant commandée par ledit premier signal d'horloge (CK1) et ayant un premier (FC3) et un dernier (FC6) étages, dans lesquels l'inversion du signal est effectuée, chacun desdits étages (FC3-FC6) comportant une première porte ET couplée à l'entrée de données d'une bascule D.

11. Circuit de synchronisation selon les revendications 6, 7 et 10, caractérisé en ce que ledit signal de réglage de la phase (CLR) commande une entrée de la première porte ET associée audit premier étage qui fournit ledit premier signal impulsionnel de validation/invalidation périodique (PIN) au niveau de sa sortie non inversée (Q) et en ce que ledit signal de déblocage (P4) est fourni au niveau de la sortie non inverseuse dudit dernier étage (FL6) dudit premier générateur d'impulsion.

12. Circuit de synchronisation selon la revendication 8, caractérisé en ce que la fréquence dudit premier signal d'horloge (CK1) est égale à deux fois la fréquence dudit deuxième signal d'horloge (CK2) et en ce que ledit deuxième générateur d'impulsions est composé d'un circuit oscillateur (FC7) comprenant une deuxième porte ET couplée à l'entrée de données d'une bascule D et commandée par ledit premier signal d'horloge (CK1), ledit signal de réglage de la phase (CLR) étant appliqué à une entrée de ladite porte ET.

13. Circuit de synchronisation selon la revendication 8, caractérisé en ce que ledit troisième circuit d'échantillonnage (FE3) comprend un multiplexeur à une sortie et deux entrées ayant une première entrée au niveau de laquelle ledit signal de sortie (DOUT) est appliqué, ayant une deuxième entrée au niveau de laquelle ledit signal d'entrée (DIN) est appliqué, ayant une entrée de sélection commandée par ledit deuxième signal impulsionnel (ES) et ayant une sortie couplée à une bascule D commandée par ledit premier signal d'horloge (CK1).

14. Circuit de synchronisation selon la revendication 2, caractérisé en ce que ledit premier moyen d'échantillonnage et de mémorisation est composé d'un multiplexeur à deux entrées/une sortie ayant une première entrée au niveau de laquelle lesdites premières valeurs d'échantillon (SA) sont appliquées, ayant une deuxième entrée au niveau de laquelle ledit troisième signal d'horloge (CK3) est appliqué, ayant une entrée de sélection commandée par ledit premier signal impulsionnel (PIN) et ayant une sortie couplée à une bascule D commandée par ledit premier signal d'horloge (CK1).

15. Circuit de synchronisation selon la revendication 2, caractérisé en ce que ledit deuxième moyen d'échantillonnage et de mémorisation est composé d'un multiplexeur à deux entrées/une sortie ayant une première entrée au niveau de laquelle lesdites deuxièmes valeurs d'échantillon (SB) sont appliquées, ayant une deuxième entrée au niveau de laquelle lesdites premières valeurs d'échantillon (SA) sont appliquées, ayant une entrée de sélection commandée par ledit premier signal impulsionnel (PIN) et ayant une sortie couplée à une bascule D commandée par ledit premier signal d'horloge (CK1).

FIG. 1

EP 0 491 090 B1

FIG.2

FIG.3

FIG.4

FIG.5